# EUROPEAN PATENT APPLICATION

(11) **EP 2 503 610 A1**
(43) Date of publication of application: **26.09.2012**
(21) Application number: 11002360.3
(22) Date of filing: 22.03.2011
(51) Int. Cl.: H01L 35/22, H01L 35/32, H01L 35/34

(54) **Structure useful for producing a thermoelectric generator, thermoelectric generator comprising same and method for producing same**

(71) Applicant: Technical University of Denmark, 2800 Kgs. Lyngby (DK)
(72) Inventor: Nong, Ngo Van, 2630 Tåstrup (DK); Pryds, Nini, 2791 Dragør (DK); Bahl, Christian Robert Haffenden, 2630 Tåstrup (DK); Smith, Anders, 3460 Birkerød (DK); Linderoth, Søren, 4000 Roskilde (DK)
(74) Representative: Grünecker, Kinkeldey, Stockmair & Schwanhäusser

(57) **Abstract**

The present invention concerns a structure useful for producing a thermoelectric generator, a thermoelectric generator comprising same and a method for producing same.
The structure comprises at least one stripe of a n-type and at least one stripe of a p-type material, either separated by a stripe of an insulating material, or provided spatially separated on an insulating material, characterized in that the structure is free from polymeric substrates. The thermoelectric generator comprises at least one of such structures, which may be present in the form of a roll or a stack. The method comprises the step of tape casting the materials required for obtaining the respective stripes of the structure or the step of co-extruding the materials required for obtaining the respective stripes of the layered structure, followed by sintering a green body obtained by tape casting or co-extrusion.

## Description

The present invention concerns a structure useful for producing a thermoelectric generator, a thermoelectric generator comprising same and a method for producing same.

### Background of the Invention

Thermoelectric generators (TEG) are devices which convert heat (temperature differences) directly into electrical energy, using a phenomenon called the "Seebeck effect" (or "thermoelectric effect"). When two dissimilar metals (conductors) or semiconductors having different Seebeck potential are in contact at each end, a voltage is obtained if the ends are at different temperatures (i.e., the Seebeck effect). Conversely, an applied electrical current can induce a temperature differential between the two ends due to the Peltier effect. Thus, a thermoelectric device can be a cooler or a heat pump which transfers heat by electric current. A typical thermoelectric generator comprises two semiconductor materials, of p- and n-doped thermoelectric elements, connected to each other and forming a thermoelectric couple. Thermoelectric couples are then connected electrically in series and thermally in parallel. A thermoelectric generator can contain one to several hundred thermoelectric couples. Thermoelectric generators can be applied in a variety of situations, which offers not only an alternative energy solution for harvesting heat but also for cooling purpsoses.

TEGs may for example be used for small size applications, where heat engines (which are bulkiers) would not be possible. Other fields of application which are currently generating interest are the use of "waste" heat/"waste" temperature differences (from any given source) for generating electricity also on a larger scale, for example in order to increase the energy efficiency of existing power plants, where still a lot of "waste" heat is generated without making any use of the energy content thereof.

In order to further broaden the use of TEGs for power generation, however, simple, reliable and up-scalable manufacturing processes must be found, since current technologies still suffer from the drawback that rather complicated and costly processes, such as photolithographic methods, are required. Further, TEGs should be as stable as possible, they should be able to work over a broad range of temperatures and they should not be too susceptible to damage by high temperatures and/or large temperature variations, for example of the "waste" heat used for generating electricity.

However, current technologies still do not allow satisfactory solutions for the objects mentioned above.

Conventional thermoelectric generators are normally produced by cutting ingot of thermoelectric material into well define bulk thermoelectric elements and bonding them onto electrodes through soldering or similar techniques. Often this technology of making thermoelectric generators is time consuming and expensive requiring the placing of hundreds of legs of either n or p-type materials close to each other and then pair them in serial. This way of manufacturing requires improvement of the thermoelectric device fabrication technology. A problem encountered with conventional production of thermoelectric generators is the notably lower yield of thermoelectric elements when the thickness of the thermoelectric elements is less than 1.5 mm. This is due to the difficulty in cutting ingot thermoelectric materials. Miniaturization of thermoelectric elements is very difficult. As a result, the number of thermoelectric pairs that can be fabricated in a thermoelectric module is limited. Another problem which is limiting the efficiency of the device is the contact resistance between the legs and the interconnectors. Thus, the overall efficiency of the thermoelectric generators is rather low. In summary, it is very difficult to produce compact, high performance thermoelectric generators using conventional methods.

US 5,959,341; US 6,025,554; US 6,127,619; and US 2009/0025772 A1 disclose thermoelectric modules, describing cumbersome processes for the production of such modules, which in particular are time consuming, still expensive and difficult to scale up.

WO 2009/148309 for example describes a method of manufacturing a TEG. The method described aims at overcoming some of the drawbacks associated with the use of photolithographic methods in the prior art. However, even the method suggested in WO 2009/148309 is a rather complicated multi-step method. Further, WO 2009/148309 requires the use of flexible, typically polymer substrates, which greatly diminishes thermal stability.

WO 2009/045862 describes another example of a prior art method for producing TEGs. In this method a p-type or n-type material is deposited on a flexible substrate and rolled up cylinders of deposited n-type and p-type material, respectively are then connected in order to produce a TEG. Similar procedures are also disclosed in WO 2010/007110, US 2008/0156364 A and JP 9107129 A. However, all these methods and the produced TEGs still suffer from various drawbacks, such as temperature restriction concerning manufacture as well as during use, since the described, polymeric flexible substrates are not stable at high temperatures. Further, mass production using these prior art techniques is hard to envisage, in particular due to the rather complicated multi step manufacturing processes.

### Objects underlying the Invention

While the promise in this technology has increased over the past 15 years due to research on thermoelectric materials, several problems still prevent commercial implementation including:
I. the need for better thermoelectric materials combining optimal thermal, electrical, and mechanical properties at high combustion temperatures
II. the electrical contacting of these materials and their integration into real-world thermoelectric generator generators, i.e. high contact resistance
III. the need for cheap, scalable and efficient manufacturing processes to produce these generators

Accordingly there is a need to provide methods for producing TEGs overcoming these drawbacks and fulfilling at least one of the objects mentioned above. In addition highly reliable, simple and cheap TEGs are sought after, so that this power generating technology can be used in more fields of application.

The overall aim of this invention is to create a high energy density, up scalable and low-cost thermoelectric generator technology that incorporates earth-abundant materials.

### Summary of the Invention

The present invention solves these objects with the subject matter of claims 1 to 15.

### Detailed Description of the Invention

The present invention provides a structure useful for producing a TEG, wherein the structure comprises at least one stripe of a n-type and at least one stripe of a p-type material, either separated by a stripe of an insulating material, or provided spatially separated on an insulating material, characterized in that the structure is free from polymeric substrates.

According to the above, a first option of the invention is a structure, where stripes of n-type (n), p-type (p) and insulating material (i) are provided side by side. Such a structure may be manufactured by known tape casting or similar methods. It is possible to assemble a large number of stripes of these types side by side to obtain a structure with multiple stripes. This may be achieved by tape casting n-type and p-type pastes separated by insulating material (parallel to the tape flow direction). The structure obtained thereby can be described as [(n)(i)(p)(i)]ₓ ("repeating units" consisting of a n-type stripe, an insulating stripe, a p-type stripe, an insulating stripe, with x being the number of repeating units provided side by side). It is preferred when one additional stripe of insulating material is provided so that the two outer stripes are insulating stripes. This secures electrical insulation, provides advantages regarding stability and offers protection to the n-type/p-type stripes.

In a preferred embodiment, the insulating stripe comprises a ceramic material. It is further preferred when the structure in accordance with the present invention consists of the stripes described above, i.e. when no further stripes are present. It is however evident that the structure in accordance with the present invention may comprise multiple stripes each of n-type and p-type material, with the required number of insulating stripes there between. Any desired number of these stripes may be present such as from 2 (i.e. one n-type and one p-type stripe) up to several hundreds of stripes, such as from 2 to 1000, and in embodiments from 10 to 500, from 50 to 300, from 75 to 200, from 80 to 150, or from 80 to 120, such as about 100 stripes etc. Structures with these numbers of stripes then additionally comprise the required number of insulating stripes, so that adjacent stripes of n-type and p-type material are properly separated.

In accordance with the present invention, a method for the cost-effective production of thermoelectric generators is provided. The present invention advantageously employs an array of thermoelectric pairs (n and p-type) produced in one process step instead of using bulk thermoelectric elements from ingot thermoelectric materials. The thermoelectric elements are obtained for example by tapecasting selectively casting the thermoelectric pairs "side by side" into an array of n and p-type materials separated by insulating materials. Location, shape and size of the individual thermoelectric elements are thereby predetermined by the pattern of the tape casting process.

When using ceramic materials for the stripes (as will be explained and illustrated further below) it is a further advantage of the present invention that the structure first is prepared from a ceramic slurry or paste (such as ceramic powder mixed with binder and optionally solvent) so that after for example tape casting and drying (at low temperatures such as 100°C as is known to the average skilled person) a green body is obtained which may be subjected to further processes, such as cutting and shaping (for example rolling up into a spiral shape), followed by sintering. Thereby the shape of the structure may be modified after the initial casting.

For example, thermoelectric generators may be prepared by cutting rectangular strips of the structure mentioned above (in a green state); these strips are flexible and made for example from ceramic material as a principal component. These strips may then for example be rolled to a shape before the sintering at a predetermined temperature of the ceramic powder is taking place. The final outcome is a multi-stage thermoelectric module.

In the present invention such a rolled cylindrical thermoelectric module is much easier to assemble, and offers access to mass production and can be scaling up, depending on practical application to give different output powers with less volume of materials compared with conventional processes.

Preferably the stripes described above are manufactured from materials which allow a simple and industrial manufacturing process, such as tape casting, spray coating, or co-extrusion etc., with tape casting being preferred. Suitable materials are in particular ceramic materials which allow as starting material the use of a slurry, so that for example a simultaneous tape casting of any desired number of stripes may be carried out. Subsequently the wet (green) bodies obtained (sheets) are then optionally subjected to a first drying step, and in any case typically cut into appropriate pieces which are then stacked or rolled up into cylinders, prior to being subjected to further sintering processes so that the final solidified structure is obtained.

Typical dimensions of stripes within the structure may be selected as follows (in relation to a structure prepared by tape casting):
Width (w): 1 to 100 mm, such as from 5 to 50 mm
Thickness (t): 0.05 to 5 mm, such as 0.1 to 2 mm, preferably 0.5 to 1 mm
Length (l) (in tape movement direction): 2 to 1000 mm, such as 5 to 200 mm, preferably 20 to 100 mm

In addition to tape casting methods also other methods for preparing the layered structure can be considered, in particular co-extrusion processes etc.

Due to the preferred use of ceramic materials drying and sintering (at temperatures of typically above 800°C) is required, so that the resulting layers should preferably by made of materials having similar thermal expansion coefficients, preferable within about 10%, more preferably within 5% or less. The final product then offers the advantage that highly stable layers are obtained, with high thermal stability as well as stability in aggressive environments, since ceramic materials are chemically stable. Tape casting of ceramics materials is also a well know technology so that cheap mass production is possible.

Suitable materials for the respective layers of the structure of the invention are as follows:
n-type materials: doped ZnAlO, LaNiO₃, CaMnO₃, Co doped beta-FeSi₂,
p-type materials: Li doped NiO, Cr doped beta-FeSi₂; doped Ca₃Co₄O₉
Insulating material: K₂O-BaO-SiO₂, BaO-Al₂O₃-SiO₂

It should be understood however, that these materials are mentioned as illustrative examples only. These materials allow the preparation of highly valuable structures which can be efficiently and reliably produced by tape casting.

The structures as described above are in particular suitable for the formation of TEGs. The n-type and p-type stripes of the sintered/burned sheets, which already have been brought into the desired shape (by rolling or stacking as described above) may then be, by using standard and well known methods, applied with contact stripes (electric conductors), such as those made from silver paste or powder, so that the desired connections between n-type and p-type stripes is made and a block is obtained. Multiple of such blocks may then be connected in the required manner by wirings so that the central unit of a TEG is obtained. By properly placing these connected blocks into suitable housings etc. a TEG is obtained. These manufacturing steps may be carried out in the order described above, it is however also possible to use other orders of the method steps, as illustrated in the Figures.

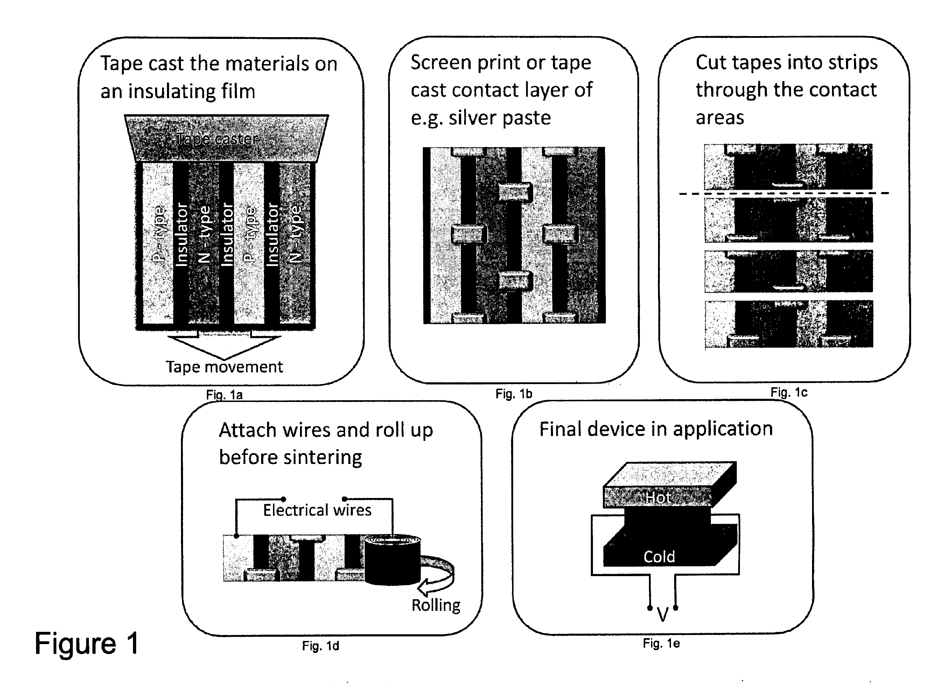

In one particular embodiment of the present invention the contact stripes may be formed already during the manufacturing steps for providing the stripes of n-type and p-type material, such as during the tape casting process. In such an embodiment these contact stripes may be provided during tape casting by applying, stripes of a suitable conducting material, such as a silver paste (see Figure 1) either by tape casting, screen printing or other suitable methods, so that the structure, prior to any subsequent process steps already comprises all required functions (n-type, p-type, insulator, connector). Each stripe of conducting material connects one p-type stripe with exactly one n-type stripe, and is not electrically connected to any other conducting stripes.

Since the essential elements, i.e. n-type, p-type and insulating layer may be obtained by simple and well known processed, an easy ways for mass production of TEGs is provided by the present invention. The TEGs of the present invention are stable, function over a broad temperature range and thereby provide the possibility of using them in a broad variety of applications.

### Brief Description of the Figures

In Figure 1 one way of obtaining a TEG in accordance with the invention is shown. In
Figure 1a the tape casting process is shown schematically for a structure comprising 4 stripes (n-type plus p-type layers) in addition to 3 insulating stripes. Figure 1b shows the application of contact layers, followed by cutting in Figure 1 c. Figure 1d then shows that electric wiring is attached, followed by winding the green ceramic body into a roll, followed by sintering. Figure 1e then finally shows the final TEG.

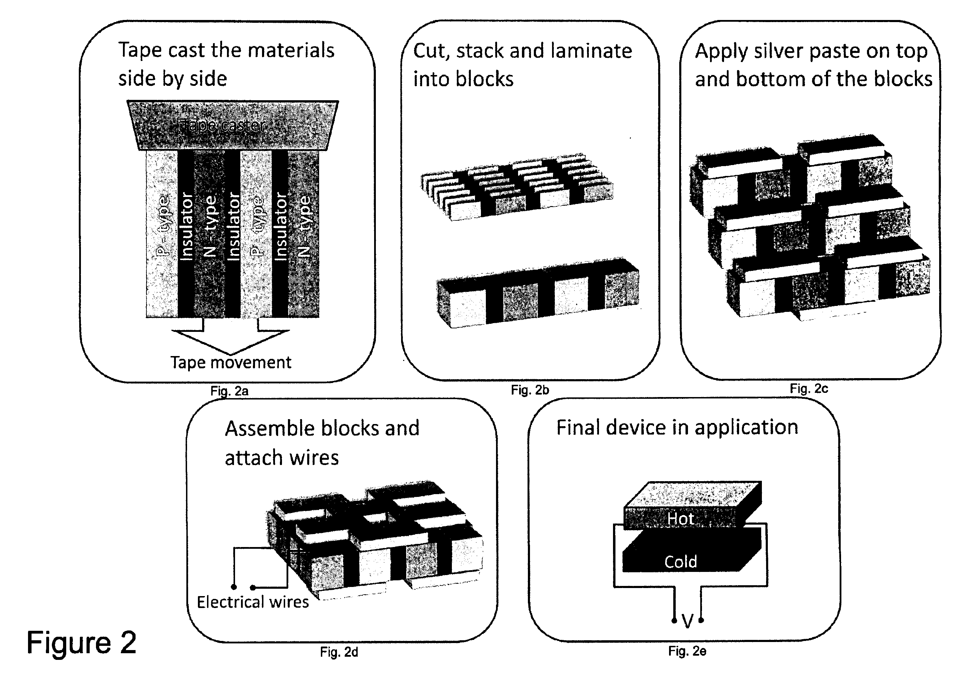

Figure 2 shows an alternative route for obtaining the structure and the TEG of the present invention. Figure 2a corresponds to Figure 1a. In figure 2b the green ceramic body is cut and stacked into blocks, which are then applied with conducting layers in Figure 2c. Figure 2d shows the assembling of blocks and the application of wiring, followed by the final TEG in Figure 2e.

The second option for a structure is accordance with the present invention is the provision of stripes of n-type and p-type material on an insulating material for example in the form of a sheet like substrate. Between each stripe of n-type and p-type material there is provided a void (spatial separation) which provides the required insulation. Such a structure may offer the advantage of higher mechanical stability (due to the insulating substrate, while still offering the advantages as outlined above (ease of manufacture etc.) All preferred embodiments described above in connection with the first option are also valid for the second option, such as choice of materials, dimensions for the stripe, manufacturing processes etc. This specific embodiment also can be prepared by tape casting methods, where first the insulating substrate is provided, followed by deposition of the n-type and p-type stripes. The voids between stripes of n-type and p-type materials are typically in the range as indicated above for the first option.

The following examples further illustrate the invention.

### Examples

A structure (I:w:t 100mm : 5mm : 1 mm) is obtained by tape casting a structure with 21 stripes ([(n)(i)(p)(i)]ₓ with x = 5, plus one insulating stripe to cover both sides of the structure with insulating stripes) n-type, insulating material and p-type were selected as follows:
Example 1: LaNiO₃/ K₂O-BaO-SiO₂/doped Ca₃Co₄O₉
Example 2: CaMnO₃/ K₂O-BaO-SiO₂/Li doped NiO
Example 3: Co doped beta-FeSi₂/ K₂O-BaO-SiO₂/Cr doped beta-FeSi₂

The sheets obtained were sintered at 900°C (Example 1), 1250°C (Example 2) and 1200°C (Example 3). Since the materials were selected so that the thermal expansion coefficients of the materials used, in particular of the n-type and p-type materials were very similar, the obtained ceramic structures did not show any damage or deformation so that highly suitable products were obtained for use in the production of TEGs.

## Claims

1. A structure useful for producing a TEG, wherein the structure comprises at least one stripe of a n-type and at least one stripe of a p-type material, either separated by a stripe of an insulating material, or provided spatially separated on an insulating material, **characterized in that** the structure is free from polymeric substrates.

2. The structure of claim 1, comprising from 2 to 1000 stripes.

3. The structure of claim 1 or 2, wherein the structure consists of stripes of a n-type material and a p-type material, each separated by an insulating stripe, and comprising stripes of conductive material each connecting one n-type stripe with one p-type stripe, and not in electrical contact with each other.

4. The structure of any one of claims 1 to 3, wherein the stripes are manufactured from materials which allow production by tape casting.

5. The structure of any one of claims 1 to 4, wherein the p-type, n-type and insulating stripes consist of ceramic materials.

6. The structure of any one of claims 1 to 5, wherein the n-type materials are selected among LaNiO₃, CaMnO₃, and Co doped beta-FeSi₂, as well as mixtures thereof.

7. The structure of any one of claims 1 to 6, wherein the p-type materials are selected among Li doped NiO, Cr doped beta-FeSi₂; and doped Ca₃Co₄O₉, as well as mixtures thereof.

8. The structure of any one of claims 1 to 7, wherein the insulating materials are selected among K₂O-BaO-SiO₂, and BaO-Al₂O₃-SiO₂, as well as mixtures thereof.

9. The structure of any one of claims 1 to 8, wherein the dimensions of n-type, p-type and insulating stripes within the structure are be selected as follows
Width (w): 1 to 100 mm, such as from 5 to 50 mm
Thickness (t): 0.05 to 5 mm, such as 0.1 to 2 mm, preferably 0.5 to 1 mm
Length (l) (in tape movement direction): 2 to 1000 mm, such as 5 to 200 mm, preferably 20 to 100 mm

10. The structure according to any one of claims 3 to 9, wherein the conductive material comprises silver.

11. A thermoelectric generator comprising at least one structure according to any one of claims 1 to 10.

12. The thermoelectric generator according to claim 11, wherein the structure according to any one of claims 1 to 10 is present in the form of a roll or a stack.

13. Method for producing the structure according to any one of claims 1 to 10, comprising the step of tape casting the materials required for obtaining the respective stripes of the structure.

14. Method for producing the structure according to any one of claims 1 to 10, comprising the step of co-extruding the materials required for obtaining the respective stripes of the layered structure.

15. Method according to claim 13 or 14, further comprising the step of sintering a green body obtained by tape casting or co-extrusion.
